# EUROPÄISCHE PATENTSCHRIFT

(11) **EP 0 944 118 B1**
(45) Veröffentlichungstag und Bekanntmachung des Hinweises auf die Patenterteilung: **21.11.2001**
(21) Anmeldenummer: 99105691.2
(22) Anmeldetag: 19.03.1999
(51) Int. Cl.: H01L 31/12, H01L 31/173, H01L 31/153, H01L 33/00, H01S 5/02

(54) **Verfahren zur Herstellung einer Halbleiteranordnung**
Method of manufacturing a semiconductor device
Procédéde fabrication d'un dispositif semiconducteur

(30) Priorität: 19.03.1998 DE 19812199
(43) Veröffentlichungstag der Anmeldung: 22.09.1999
(73) Patentinhaber: Infineon Technologies AG, 81669 München (DE)
(72) Erfinder: Lell, Alfred, 93142 Maxhütte-Haidhof (DE)
(74) Vertreter: Fischer, Volker, Dipl.-Ing.

(56) Entgegenhaltungen:
- WO-A-91/18421
- DE-A- 4 205 324
- US-A- 5 608 233

## Beschreibung

Die Erfindung betrifft ein Verfahren zur Herstellung einer mindestens zwei Halbleiterbauelemente umfassenden Halbleiteranordnung sowie eine derartige Halbleiteranordnung.

Es ist bereits bekannt, Halbleiterbauelemente wie beispielsweise Optohalbleiterbauelemente durch epitaktisches Aufwachsen einer Schichtstruktur auf einem n- oder p-dotierten Halbleitersubstrat herzustellen. Dabei werden auf dem Halbleitersubstrat (Wafer) mehrere Einzelbauelemente mit gleicher Schichtstruktur aufgebaut und nachfolgend durch Auseinandersägen des Substrats in einzelne Bauteilchips getrennt. Eine aus mehreren Bauelementen aufgebaute Halbleiteranordnung (beispielsweise eine optoelektronische Sende- und Empfangsanordnung) wird dann durch eine Montage der entsprechenden Bauteilchips realisiert.

Ferner ist es bereits bekannt, im Rahmen von CMOS-Prozessen lokal n- oder p-dotierte Oberflächenbereiche auf einem Halbleitersubstrat aufzubringen. Diese lokale oder bereichsweise Dotierung des Halbleitersubstrats wird durch Ionenimplantation oder thermische Dotierung erreicht, wobei die zu dotierenden lokalen Bereiche - beispielsweise die Source/Drain-Bereiche eines MOSFETs - mittels einer zuvor aufgebrachten Maske festgelegt werden.

Die Patentschrift US 4 614 958 beschreibt ein optoelektronisches Bauelement, das einen Lichtsender und einen Lichtempfänger aufweist, die auf einem gemeinsamen Halbleitersubstrat aufgebaut sind. Die jeweils substratseitig unterste elektrisch leitfähige Schicht des Lichtsenders und des Lichtempfängers stehen über das Substrat elektrisch miteinander in Verbindung.

Weitere Bauelementstrukturen, die zwei oder mehr über ein gemeinsames Halbleitersubstrat elektrisch miteinander verbundene Halbleiterbauelemente umfassen, sind in der internationalen Patentanmeldung WO 91-18421 A1 und in der deutschen Patentanmeldung DE 42 05 324 A1 beschrieben.

Der vorliegenden Erfindung liegt die Aufgabe zugrunde, ein Verfahren anzugeben, das es ermöglicht, mit geringem Aufwand eine mindestens zwei Halbleiterbauelemente umfassende Halbleiteranordnungen herzustellen. Ferner zielt die Erfindung darauf ab, eine aus zumindest zwei Halbleiterbauelementen aufgebaute kostengünstig herstellbare Halbleiteranordnung zu schaffen.

Die der Erfindung zugrundeliegende Aufgabe wird durch die Merkmale der Ansprüche 1 und 8 gelöst.

Durch die Ausbildung der zwei unterschiedlich dotierten Oberflächenbereiche an der Oberseite des Halbleitersubstrats wird erreicht, daß die beiden aktiven Schichtstrukturen, von denen jeweils eine auf einem der dotierten Oberflächenbereiche des Halbleitersubstrats angeordnet ist, aufgrund der unterschiedlichen Dotierung dieser Oberflächenbereiche nicht über das Halbleitersubstrat elektrisch kurzgeschlossen sind. Dies ermöglicht es, die beiden Schichtstrukturen getrennt elektrisch anzusteuern und somit auf ein und demselben Halbleitersubstrat unabhängig voneinander betreibbare Halbleiterbauelemente auszubilden.

Durch die erfindungsgemäß geschaffene elektrische Entkopplung der Halbleiterbauelemente lassen sich in einfacher Weise auch integrierte Halbleiteranordnungen mit wesentlich mehr als zwei Halbleiterbauelementen aufbauen. Das bisher erforderliche Zersägen des Halbleitersubstrats zur Vereinzelung der Halbleiterbauelemente und der nachfolgende Montageschritt, in dem die einzelnen Halbleiterbauelemente zu der gewünschten Halbleiteranordnung aus mehreren Bauelementen zusammengesetzt werden, kann somit entfallen.

Der hier verwendete Begriff "Halbleiterbauelement" ist in einem weiten Sinne zu verstehen. Er umfaßt sämtliche einzelfunktionsfähige Halbleiterstrukturen wie beispielsweise Laserdioden, Empfangsdioden usw.

Eine Ausführungsform des erfindungsgemäßen Verfahrens kennzeichnet sich dadurch, daß die Ausbildung der zumindest zwei unterschiedlich dotierten Oberflächenbereiche durch eine Umdotierung eines der Oberflächenbereiche geschaffen wird. Diese Ausführungsform umfaßt das Abscheiden einer Maskenschicht auf der Substratoberseite, das lithographische Strukturieren der Maskenschicht, derart, daß einer der auszubildenden Oberflächenbereiche von der Maskenschicht abgedeckt bleibt und der andere auszubildende Oberflächenbereich freiliegt, das Umdotieren des freiliegenden Oberflächenbereichs auf eine der Dotierung des Halbleitersubstrats entgegengesetzte p- oder n-Dotierung oder auf eine nichtleitende Dotierung und das Entfernen der Maskenschicht.

Der Schritt des Umdotierens wird dabei vorzugsweise durch Diffusion eines Dotierstoffes in den freiliegenden Oberflächenbereich des Halbleitersubstrats durchgeführt. Wird beim Umdotieren ein entgegengesetzt zur n- oder p-Dotierung des Halbleitersubstrats p- oder n-dotierter Oberflächenbereich geschaffen, können beispielsweise As- oder P-haltige Dotiergase zum Einsatz kommen. Für die Herstellung eines nichtleitend dotierten Oberflächenbereichs kann H₂ als Dotierstoff eingesetzt werden.

Diese Ausführungsform weist den Vorteil auf, daß keine zusätzliche Epitaxieschicht auf der Substratoberseite abgeschieden werden muß, sondern der entgegengesetzt dotierte Oberflächenbereich bzw. der nichtleitend dotierte Oberflächenbereich unmittelbar auf der Oberfläche des Halbleitersubstrats erzeugt wird.

Gemäß der Erfindung werden die beiden Schichtstrukturen als gemeinsames Schichtsystem gleichzeitig auf dem Halbleitersubstrat aufgewachsen, wobei die nachfolgende Trennung des Schichtsystems in die beiden Schichtstrukturen durch einen Naß- und/oder Trockenätzschritt und/oder durch Sägen herbeigeführt wird. Da verschiedenartige Halbleiterbauelemente häufig ein identisch aufgebautes aktives Schichtsystem aufweisen (z.B. Sende- und Empfangsdioden in Optokopplern oder Laser- und Monitordioden bei Glasfaseranwendungen) kann auf diese Weise ein elektrisch voneinander getrenntes Bauelementepaar der genannten Art erzeugt werden. Neben der bereits angesprochenen einfachen Herstellung besteht ein weiterer wesentlicher Vorteil des erfindungsgemäβen integrierten Aufbaukonzeptes darin, daß der bisher erforderliche Justageschritt der zwei oder mehr Halbleiterbauelemente nunmehr entfallen kann.

Das erfindungsgemäße Verfahren weist eine große Variabilität hinsichtlich der Anzahl und der Anordnung der unterschiedlich dotierten Oberflächenbereiche sowie der Strukturierung der einzelnen aktiven Schichtstrukturen auf. Nach einer bevorzugten Ausführungsvariante der Erfindung kann eine Vielzahl von unterschiedlich dotierten Oberflächenbereichen in Form eines Musters, beispielsweise eines Schachbrettmusters, auf der Substratoberfläche ausgebildet werden. Dies ermöglicht die Herstellung von hochintegrierten Halbleiteranordnungen, in denen die Halbleiterbauelemente in Zeilen- oder Arraystruktur selbstjustierend angeordnet sind.

Weitere vorteilhafte Ausgestaltungen der Erfindung sind in den Unteransprüchen angegeben.

Nachfolgend wird die Erfindung in beispielhafter Weise anhand eines Ausführungsbeispiels unter Bezugnahme auf die Zeichnung erläutert; in dieser zeigt:
- Fig. 1: eine schematische Darstellung eines Halbleitersubstrats mit einem oberflächenseitig umdotierten Substratbereich;
- Fig. 2: das in Fig. 1 gezeigte Halbleitersubstrat mit einem ganzflächig epitaktisch aufgewachsenen Halbleiterschichtsystem; und
- Fig. 3: eine schematische Darstellung eines aus dem Schichtsystem der Fig. 2 gebildeten Bauelementepaars.

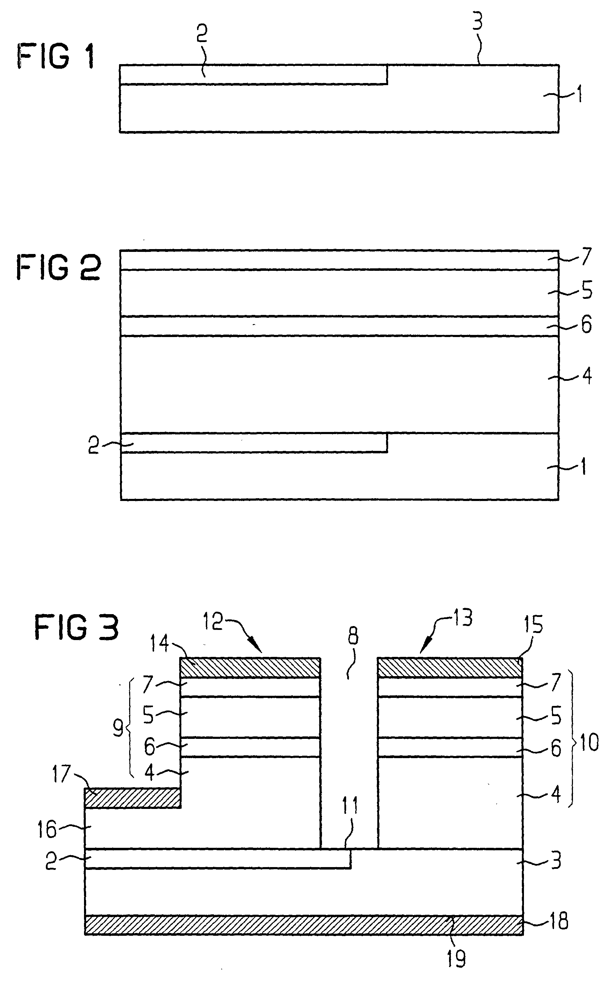

Nach Fig. 1 wird zur Herstellung einer optischen Sender- und Empfängeranordnung an einem herstellerseitig n-dotierten, beispielsweise aus GaAs, GaP, InP oder SiC bestehenden Halbleitersubstrat 1 durch partielles oberflächenseitiges Umdotieren ein p-dotierter Oberflächenbereich 2 ausgebildet. Zu diesem Zweck wird in nicht dargestellter Weise zunächst eine Diffusionsmaske aus Al₂O₃, SiO₂ oder Si₃N₄ auf der Oberseite des Substrats 1 abgeschieden und anschließend phototechnisch so strukturiert, daß der Oberflächenbereich 2 freiliegt. Danach wird das Substrat 1 einer dotiergas haltigen Atmosphäre ausgesetzt, wobei der p-Dotierstoff in dem von der Diffusionsmaske ungeschützten Bereich in das Substrat 1 eindringt und dabei die Umdotierung des Oberflächenbereichs 2 herbeiführt. Die Stärke der p-Umdotierung kann dabei über die Dotiergaskonzentration und die Temperatur des Substrats 1 nach Wunsch eingestellt werden. Die Tiefe des umdotierten Oberflächenbereichs 2 ist im wesentlichen durch die Zeitdauer gegeben, über die das Substrat 1 dem Dotiergas ausgesetzt wird.

An den substratseitigen Rändern des umdotierten Oberflächenbereichs 2 bildet sich ein pn Übergang aus, der den p-umdotierten Oberflächenbereich 2 von dem maskierten, weiterhin n-dotierten Oberflächenbereich 3 elektrisch entkoppelt.

In nicht dargestellter Weise kann anstelle einer partiellen Umdotierung des n-Substrats in einen p-leitenden Oberflächenbereich auch eine Umdotierung in einen nichtleitenden Oberflächenbereich vorgesehen sein. Dies kann durch Verwendung von H₂ als Dotierstoff erfolgen, welcher im Rahmen eines Implantationsschrittes unter Verwendung einer Implantationsmaske, die der vorstehend erwähnten Diffusionsmaske entspricht, in den freiliegenden Oberflächenbereich eingebracht wird. Die H₂-Dotierung bewirkt, daß der entsprechend umdotierte Oberflächenbereich elektrisch nichtleitend ist, wodurch ebenfalls eine elektrische Trennung der auf den Oberflächenbereichen 2, 3 aufzubringenden Schichtstrukturen ermöglicht wird.

Nachfolgend wird durch einen Ätzschritt in nicht dargestellter Weise die Diffusionsmaske (bzw. die Implantationsmaske) über dem Oberflächenbereich 3 entfernt.

Im Anschluß daran erfolgt nach zuvor gegebenenfalls wiederholt durchgeführten Oberflächenreinigungsschritten das ganzflächige epitaktische Aufwachsen eines aktiven Halbleiterschichtsystems. Das Aufwachsen kann durch einen MOCVD-Prozeß, beispielsweise MOVPE, ein LPE-Verfahren, ein MBE-Verfahren oder auch ein MOMBE-Verfahren bewirkt werden. Zunächst wird eine n-dotierte Epitaxieschicht 4 auf die Substratoberfläche aufgebracht. Die Stärke der Dotierung der Epitaxieschicht 4 kann der Stärke der Substratdotierung entsprechen. Beim nachfolgenden Aufwachsen einer p-dotierten Epitaxieschicht 5 bildet sich zwischen der n-dotierten Epitaxieschicht 4 und der p-dotierten Epitaxieschicht 5 ein pn-Übergang aus, der die aktive Zone 6 der entstehenden optischen Halbleiterbauelemente darstellt. Oberhalb der p-dotierten Epitaxieschicht 5 wird eine p⁺-dotierte Epitaxieschicht 7 mit guter elektrischer Leitfähigkeit oder auch eine Metallsilizidschicht abgeschieden, die als Anschlußstruktur für eine spätere elektrische Kontaktierung der Halbleiterbauelemente dient.

Das gemäß Fig. 2 ganzflächig aufgewachsene epitaktische Schichtsystem 4, 5, 6 und 7 wird dann durch Ausbildung eines Isolationsgrabens 8 in zwei elektrisch unabhängige Schichtstrukturen 9 und 10 getrennt. Der Isolationsgraben 8 kann durch einen Naß- oder Trockenätzschritt oder auch durch ein Ansägen des Schichtsystems 4, 5, 6 und 7 in dieses eingebracht werde. Dabei werden sämtliche Schichten 4, 5, 6 und 7 des Schichtsystems in zwei Teilschichten getrennt und elektrisch unterbrochen. Die Lage des Isolationsgrabens 8 ist so gewählt, daß die Grenzlinie 11 zwischen den beiden entgegengesetzt dotierten Oberflächenbereichen 2 und 3 innerhalb des Isolationsgrabens 8 liegt. Dies gewährleistet, daß die untersten leitfähigen Epitaxieschichten 4 der beiden Schichtstrukturen 9, 10 nicht substratseitig kurzgeschlossen sind.

In dem dargestellten Beispiel bildet die auf dem p-dotierten Oberflächenbereich 2 abgelagerte Schichtstruktur 9 eine optische Empfangsdiode 12, während die auf dem n-dotierten Oberflächenbereich 3 aufgebrachte Schichtstruktur 10 eine Sendediode 13 ausbildet.

Die elektrische Kontaktierung der Empfangsdiode 12 und der Sendediode 13 kann auf folgende Weise erfolgen.

Zur Ausbildung von p-Kontakten werden auf die Oberseiten der p⁺-dotierten Epitaxieschichten 7 der beiden Schichtstrukturen 9, 10 jeweils Kontaktflächen 14, 15 aufgebracht, die aus einem Metall (z.B. Al, Au oder einem Dreischichtsystem aus Ti-Pt-Au oder Cr-Pt-Au) bestehen und an denen elektrische Zuleitungen angebracht werden können. Die Kontaktflächen 14, 15 können auch bereits vor der Bildung des Isolationsgrabens 8 als eine weitere durchgängige Kontaktierungsschicht auf das Schichtsystem aufgebracht worden sein.

Die n-seitige elektrische Kontaktierung erfolgt für die Empfangsdiode 12 an einem zuvor durch einen Ätzprozeß freigelegten Stufenabschnitt 16 der n-dotierten Epitaxieschicht 4, auf welchem eine metallische Kontaktfläche 17 aufgebracht wird. Eine entsprechende für die Sendediode 13 vorgesehene Kontakfläche 18 ist an der Rückseite 19 des Halbleitersubstrats 1 angeordnet.

Für den Fall, daß die Sendediode 13 auf einem nichtleitenden (beispielsweise H₂-dotierten) Oberflächenbereich aufgebaut ist, erfolgt die n-seitige Kontaktierung der Sendediode 13 nicht an der Substratrückseite sondern - analog zur Empfangsdiode 12 - ebenfalls an einem entsprechenden Stufenabschnitt der n-dotierten Epitaxieschicht 4.

Die Fig. 3 macht deutlich, daß durch das erfindungsgemäße Verfahren eine gegenseitige lagemäßige Fehlausrichtung der Sende- und Empfangsdioden 12, 13 ausgeschlossen ist, weil deren aktive Zonen 6 stets auf gleicher Höhe liegen und parallel zueinander verlaufen und ferner die Dioden 12, 13 durch das erfindungsgemäße Verfahren unter einem definiert vorgegebenen Abstand angeordnet werden können.

## Patentansprüche

1. Verfahren zur Herstellung einer mindestens zwei Halbleiterbauelemente umfassenden Halbleiteranordnung, das die Schritte aufweist:
a) Bereitstellen eines Halbleitersubstrats (1);
b) Ausbilden von mindestens zwei unterschiedlich dotierten Oberflächenbereichen (2, 3) in der Oberfläche des Halbleitersubstrats (1),
- in dem eine Maskenschicht auf der Oberfläche des Halbleitersubstrats (1) abgeschieden wird, die Maskenschicht lithographisch derart strukturiert wird, so daß einer der auszubildenden Oberflächenbereiche (3) von der Maskenschicht abgedeckt bleibt und der andere auszubildende Oberflächenbereich (2) freiliegt,
- daß der freiliegende Oberflächenbereich (2) auf eine der Dotierung des Halbleitersubstrats (1) entgegengesetzte p- oder n-Dotierung oder auf eine nicht leitende Dotierung umdotiert wird
- und die Maskenschicht entfernt wird;
c) anschließend aufbauen eines aus mehreren Schichten (4, 5, 6, 7) bestehenden Schichtsystems;
d) nachfolgend ausbilden eines Isolationsgrabens (8) in dem Schichtsystem, welcher das Schichtsystem in die aktiven Schichtstrukturen (9, 10) auftrennt, die jeweils ein Halbleiterelement (12, 13) bilden, wobei das Halbleiterelement (12) auf dem umdotierten Oberflächenbereich (2) und das Halbleiterelement (13) auf dem Oberflächenbereich (3) angeordnet ist und die jeweils substratseitig untersten elektrisch leitfähigen Schichten (4) der aktiven Schichtstrukturen (9, 10) elektrisch voneinander getrennt sind.

2. Verfahren nach Anspruch 1,
**dadurch gekennzeichnet, daß**
die Maskenschicht eine Maske aus Al₂O₃, SiO₂ oder Si₃N₄ ist.

3. Verfahren nach einem der Ansprüche 1 oder 2,
**dadurch gekennzeichnet, daß**
die Umdotierung mit Phosphor, Arsen oder Wasserstoff haltigem Dotierstoff durch thermische Dotierung, durch Ionenimplantation oder durch Diffusion von Dotieratomen aus der Gasphase oder einer zuvor abgeschiedenen Dotierschicht in den freiliegenden Oberflächenbereich (2) des Halbleitersubstrats (1) erfolgt.

4. Verfahren nach einem der Ansprüche 1 bis 3,
**dadurch gekennzeichnet, daß**
das aus mehreren Schichten (4, 5, 6, 7) gebildete Schichtsystem durch ein MOCVD-Verfahren, ein MOVPE, ein LPE-Verfahren, ein MBE-Verfahren oder ein MOMBE-Verfahren ausgeführt wird.

5. Verfahren nach einem der Ansprüche 1 bis 4,
**dadurch gekennzeichnet, daß**
der Isolationsgraben (8) durch einen Naß- und/oder Trokkenätzschritt und/oder durch Ansägen des Schichtsystems gebildet wird.

6. Verfahren nach einem der Ansprüche 1 bis 5,
**dadurch gekennzeichnet, daß**
eine Vielzahl von unterschiedlich dotierten Oberflächenbereichen (2, 3) in Form eines Musters auf der Substratoberfläche ausgebildet werden.

7. Verfahren nach Anspruch 6,
**dadurch gekennzeichnet, daß**
das Muster ein regelmäßiges Muster, oder ein Schachbrettmuster ist.

8. Halbleiteranordnung, die mindestens zwei Halbleiterbauelemente umfaßt,
- mit einem Halbleitersubstrat (1), in dessen Oberfläche ein dotierter Bereich (2) eingebracht ist, der eine dem Halbleitersubstrat (1) entgegengesetzte Dotierung aufweist;
- mit zumindest zwei jeweils aus mehreren Schichten (4, 5, 6, 7) aufgebauten, jeweils einem der Halbleiterbauelemente (12, 13) zugeordneten aktiven Schichtstrukturen (9, 10);
- wobei die Schichtstruktur (9) auf dem dotierten Bereich (2) und die Schichtstruktur (10) auf dem Bereich (3) der Oberfläche des Substrats (1) angeordnet ist und
- wobei deren jeweils substratseitig untersten elektrisch leitfähigen Schichten (4) elektrisch voneinander getrennt sind.

9. Halbleiteranordnung nach Anspruch 8,
**dadurch gekennzeichnet, daß**
die aktiven Schichtstrukturen (9, 10) einer optischen Sendediode (13) und einer optischen Empfangsdiode (12) zugeordnet sind.

10. Halbleiteranordnung nach einem der Ansprüche 8 oder 9,
**dadurch gekennzeichnet, daß**
die Halbleiteranordnung eine Vielzahl von Halbleiterbauelementen (12, 13) umfaßt, die in Zeilen- oder Arraystruktur auf dem Halbleitersubstrat (1) angeordnet sind.

## Claims

1. Method for fabricating a semiconductor arrangement comprising at least two semiconductor components which has the following steps:
a) a semiconductor substrate (1) is provided;
b) at least two differently doped surface regions (2, 3) are produced in the surface of the semiconductor substrate (1)
- by depositing a mask layer on the surface of the semiconductor substrate (1) and lithographically structuring the mask layer such that one of the surface regions (3) to be produced remains covered by the mask layer and the other surface region (2) to be produced is exposed,
- reversing the doping of the exposed surface region (2) to form a p- or n-doping which is the opposite of the doping of the semiconductor substrate (1) or to form a nonconductive doping,
- and removing the mask layer;
c) a layer system comprising a plurality of layers (4, 5, 6, 7) is then constructed;
d) an insulating trench (8) is subsequently produced in the layer system which splits the layer system into the active layer structures (9, 10), which respectively form a semiconductor element (12, 13), the semiconductor element (12) being arranged on the surface region (2) with reversed doping, and the semiconductor element (13) being arranged on the surface region (3), and those electrically conductive layers (4) of the active layer structures (9, 10) which are respectively bottommost on the substrate side being electrically isolated from one another.

2. Method according to Claim 1,
**characterized in that**
the mask layer is a mask made of Al₂O₃, SiO₂ or Si₃N₄.

3. Method according to one of Claims 1 or 2,
**characterized in that**
doping reversal using dopant which contains phosphorus, arsenic or hydrogen is effected by means of thermal doping, by means of ion implantation or by diffusing doping atoms from the vapour phase or a previously deposited doping layer into the exposed surface region (2) of the semiconductor substrate (1).

4. Method according to one of Claims 1 to 3,
**characterized in that**
the layer system formed from a plurality of layers (4, 5, 6, 7) is implemented using an MOCVD method, an MOVPE, an LPE method, an MBE method or an MOMBE method.

5. Method according to one of Claims 1 to 4,
**characterized in that**
the insulating trench (8) is formed using a wet and/or dry etching step and/or by sawing into the layer system.

6. Method according to one of Claims 1 to 5,
**characterized in that**
a multiplicity of differently doped surface regions (2, 3) are produced in the form of a pattern on the substrate surface.

7. Method according to Claim 6,
**characterized in that**
the pattern is a regular pattern, or a chessboard pattern.

8. Semiconductor arrangement comprising at least two semiconductor components,
- having a semiconductor substrate (1) into whose surface a doped region (2) is introduced which has an opposite doping to the semiconductor substrate (1);
- having at least two active layer structures (9, 10) which are respectively made up of a plurality of layers (4, 5, 6, 7) and are respectively associated with one of the semiconductor components (12, 13);
- the layer structure (9) being arranged on the doped region (2) and the layer structure (10) being arranged on the region (3) of the surface of the substrate (1), and
- the electrically conductive layers (4) thereof which are respectively bottommost on the substrate side being electrically isolated from one another.

9. Semiconductor arrangement according to Claim 8,
**characterized in that**
the active layer structures (9, 10) are associated with an optical transmission diode (13) and an optical reception diode (12).

10. Semiconductor arrangement according to one of Claims 8 or 9,
**characterized in that**
the semiconductor arrangement comprises a multiplicity of semiconductor components (12, 13) which are arranged in a row structure or array structure on the semiconductor substrate (1).

## Revendications

1. Procédé de fabrication d'un dispositif à semi-conducteur comportant au moins deux composants à semi-conducteur, qui comporte les stades qui consistent :
a) à prendre un substrat (1) semi-conducteur ;
b) à constituer au moins deux zones (2, 3) superficielles dopées différemment à la surface du substrat (1) semi-conducteur,
- dans lequel une couche de masque est déposée à la surface du substrat (1) semi-conducteur, la couche de masque est structurée par voie lithographique de façon que l'une des zones (3) superficielle constituée reste recouverte par la couche de masque et l'autre zone (2) superficielle constituée soit dégagée,
- la zone (2) superficielle dégagée étant redopée à un dopage p ou à un dopage n opposé au dopage du substrat (1) semi-conducteur ou à un dopage non conducteur,
- et la couche de masque est enlevée ;
c) à former ensuite un système stratifié constitué de plusieurs couches (4, 5, 6, 7à) ;
d) à constituer ensuite un sillon (8) d'isolement dans le système stratifié, qui sépare le système stratifié en les structures (9, 10) stratifiées actives qui forment respectivement un élément (12, 13) à semi-conducteur, l'élément (12) à semi-conducteur étant disposé sur la zone (2) superficielle redopée et l'élément (13) à semi-conducteur sur la zone (3) superficielle et à séparer électriquement les unes des autres les couches (4) électriquement conductrices les plus basses du côté du substrat des structures (9, 10) stratifiées actives.

2. Procédé suivant la revendication 1, **caractérisé en ce que** la couche de masque est un masque en Al₂O₃, en SiO₂ ou en Si₃N₄.

3. Procédé suivant l'une des revendications 1 ou 2, **caractérisé en ce qu'**il consiste à effectuer le redopage par une substance de dopage contenant du phosphore, de l'arsenic ou de l'hydrogène par dopage thermique, par implantation d'ions ou par diffusion d'atomes de dopage en phase gazeuse ou par une couche de dopage déposée au préalable dans la zone (2) superficielle dégagée du substrat (1) semi-conducteur.

4. Procédé suivant l'une des revendications 1 à 3, **caractérisé en ce qu'**il consiste à réaliser le système stratifié formé de plusieurs couches (4, 5, 6, 7) par un procédé MOCVD, un MOVPE, un procédé LPE, un procédé MBE ou un procédé MOMBE.

5. Procédé suivant l'une des revendications 1 à 4, **caractérisé en ce qu'**il consiste à former le sillon (8) d'isolement par un stade d'attaque chimique en voie humide ou en voie sèche et/ou en sciant le système stratifié.

6. Procédé suivant l'une des revendications 1 à 5, **caractérisé en ce qu'**il consiste à constituer une pluralité de zones (2, 3) superficielles dopées différemment sous la forme d'un motif sur la surface du substrat.

7. Procédé suivant la revendication 6, **caractérisé en ce que** le motif est un motif régulier ou un motif en échiquier.

8. Dispositif à semi-conducteur qui comprend au moins deux composants à semi-conducteur,
- comprenant un substrat (1) semi-conducteur à la surface duquel est ménagée une zone (2) dopée qui a un dopage opposé au substrat (1) semi-conducteur ;
- comprenant au moins deux structures (9, 10) stratifiées actives associées respectivement à l'un des composants (12, 13) semi-conducteur ;
- la structure (9) stratifiée étant disposée sur la zone (2) dopée et la structure (10) stratifiée étant disposée sur la zone (3) de la surface du substrat (1), et
- leurs couches (4) électriquement conductrices les plus basses du côté du substrat étant séparées électriquement les unes des autres.

9. Dispositif à semi-conducteur suivant la revendication 8, **caractérisé en ce que** les structures (9, 10) stratifiées actives sont associées à une diode (13) optique d'émission et à une diode (12) optique de réception.

10. Dispositif à semi-conducteur suivant l'une des revendications 8 ou 9, **caractérisé en ce que** le dispositif à semi-conducteur comprend une pluralité de composants (12, 13) à semi-conducteur, qui sont disposés suivant une structure en ligne ou en réseau sur le substrat (1) semi-conducteur.
